# EUROPEAN PATENT APPLICATION

(11) **EP 4 002 424 A1**
(43) Date of publication of application: **25.05.2022**
(21) Application number: 21208217.6
(22) Date of filing: 15.11.2021
(51) Int. Cl.: H01J 49/14

(54) **MIXED GAS CLUSTER ION BEAM GENERATOR AND MASS SPECTROMETER INCLUDING THE SAME**

(30) Priority: 19.11.2020 KR 20200155638
(71) Applicant: Korea Basic Science Institute, Daejeon 34133 (KR)
(72) Inventor: LEE, Sang Ju, Gimhae-si 50830 (KR); CHOI, Myoung Choul, Cheongju-si 28124 (KR); CHOI, Chang Min, Cheongju-si 28425 (KR); HONG, Aram, Cheongju-si 28120 (KR); BAEK, Ji Young, Sejong-si 30064 (KR)
(74) Representative: DREISS Patentanwälte PartG mbB

(57) **Abstract**

A mixed gas cluster ion beam generator may include a nozzle chamber to contain a first mixed gas which is a mixed gas that is a mix of a first gas and a second gas, a cluster nozzle to spray gas received from the nozzle chamber in a cluster form, an ionizer to ionize a gas cluster sprayed by the cluster nozzle, and an ion accelerator to emit an ion beam to the outside by accelerating the gas cluster ionized by the ionizer by generating a potential difference to the ionized gas cluster.

## Description

### CROSS-REFERENCE TO RELATED APPLICATION

This application claims the benefit of Korean Patent Application No. 10-2020-0155638 filed on November 19, 2020, in the Korean Intellectual Property Office, the entire disclosure of which is incorporated herein by reference for all purposes.

### BACKGROUND

### 1. Field of the Invention

One or more example embodiments relate to a mixed gas cluster ion beam generator and mass spectrometer including the same.

### 2. Description of the Related Art

A gas cluster ion beam (GCIB) ionizing a thermion by emitting the thermion is used for carrying out an in-depth analysis on solid material and compound imaging.

To generate a gas cluster, a monoatomic molecule, a diatomic molecule, or a polyatomic molecule, such as argon (Ar), carbon dioxide (CO₂), water (H₂O), and fullerene (C₆₀) is used and generally, Ar is widely used.

However, a GCIB generates a secondary ion less efficiently than a liquid metal ion beam (LMIB), thus a GCIB is not an efficient means for analysis.

Accordingly, for generating a GCIB appropriate for mass spectrometry, that is, to generate a secondary ion more efficiently, there is a demand for a method and apparatus for generating a GCIB that includes a high density primary ion beam.

The above description is information the inventor(s) acquired during the course of conceiving the present disclosure, or already possessed at the time, and is not necessarily art publicly known before the present application was filed.

### SUMMARY

Example embodiments provide a mixed gas cluster ion beam generator and mass spectrometer including the same.

According to an aspect, there is provided a mixed gas cluster ion beam generator including a nozzle chamber to contain a first mixed gas which is a mixed gas that is a mix of a first gas and a second gas, a cluster nozzle to spray gas received from the nozzle chamber in a cluster form, an ionizer to ionize a gas cluster sprayed by the cluster nozzle, and an ion accelerator to emit an ion beam to an outside by accelerating the gas cluster ionized by the ionizer by generating a potential difference to the ionized gas cluster.

The mixed gas cluster ion beam generator may further include a skimmer to selectively transfer the gas cluster sprayed by the cluster nozzle to the ionizer.

The mixed gas cluster ion beam generator may further include a high pressure vessel to contain a second mixed gas which is a mixed gas that is a mix of the first gas and the second gas, and a high pressure valve to adjust a size of the gas cluster sprayed by the cluster nozzle by controlling fluid pressure of the second mixed gas flowing into the cluster nozzle from the high pressure vessel.

A melting point of the second gas may be lower than a melting point of the first gas. The first gas may be argon, and the second gas may be carbon dioxide.

A ratio of carbon dioxide in the mixed gas of the first gas and the second gas may be 10% to 20%.

A ratio of carbon dioxide in the mixed gas of the first gas and the second gas may be 10% to 17.5%.

According to an aspect, there is provided a mass spectrometer including a mixed gas cluster ion beam generator, a sample plate to support a sample to be hit by a gas cluster ion beam generated by the mixed gas cluster ion beam generator, and an analyzer to detect a secondary ion secondarily emitted from a surface of the sample, wherein the mixed gas cluster ion beam generator may include a nozzle chamber to contain a first mixed gas which is a mixed gas that is a mix of a first gas and a second gas, a cluster nozzle to spray gas received from the nozzle chamber in a cluster form, an ionizer to ionize a gas cluster sprayed by the cluster nozzle, and an ion accelerator to emit an ion beam to an outside by accelerating the gas cluster ionized by the ionizer by generating a potential difference to the ionized gas cluster.

According to an aspect, there is provided a method of generating a mixed gas cluster ion beam including providing a mixed gas of a first gas and a second gas to a cluster nozzle, forming a gas cluster by spraying the mixed gas through the cluster nozzle, ionizing the gas cluster, and generating an ion beam by accelerating the ionized gas cluster.

A melting point of the second gas may be lower than a melting point of the first gas. The first gas may be argon and the second gas may be carbon dioxide.

A ratio of carbon dioxide in the mixed gas may be 10% to 20%.

A ratio of carbon dioxide in the mixed gas may be 10% to 17.5%.

Additional aspects of example embodiments will be set forth in part in the description which follows and, in part, will be apparent from the description, or may be learned by practice of the disclosure.

According to example embodiments, a mixed gas cluster ion beam generator and mass spectrometer including the same may enhance primary ion beam intensity and secondary ion ionization efficiency by setting an optimal mixing ratio of a mixed gas.

### BRIEF DESCRIPTION OF THE DRAWINGS

These and/or other aspects, features, and advantages of the invention will become apparent and more readily appreciated from the following description of example embodiments, taken in conjunction with the accompanying drawings of which:
FIG. 1 is a diagram illustrating a mixed gas cluster ion beam generator according to an example embodiment;
FIG. 2 is a block diagram illustrating a mixed gas cluster ion beam generator according to an example embodiment;
FIG. 3 is a graph illustrating changes in an intensity of a secondary ion measured based on a mixing ratio of gas used in a mixed gas cluster ion beam generator according to an example embodiment;
FIG. 4 is a graph illustrating changes in current of a primary ion beam measured based on a mixing ratio of gas used in a mixed gas cluster ion beam generator according to an example embodiment; and
FIG. 5 is a diagram illustrating a mass spectrometer including a mixed gas cluster ion beam generator according to an example embodiment.

### DETAILED DESCRIPTION

Hereinafter, embodiments of the present disclosure will be described with reference to the accompanying drawings. Regarding the reference numerals assigned to the components in the drawings, it should be noted that the same components will be designated by the same reference numerals, wherever possible, even though they are shown in different drawings. Also, in the description of the embodiments, detailed description of well-known related structures or functions will be omitted when it is deemed that such description will cause ambiguous interpretation of the present disclosure.

Also, in the description of the components, terms such as first, second, A, B, (a), (b) or the like may be used herein when describing components of the present disclosure. These terms are used only for the purpose of discriminating one constituent element from another constituent element, and the nature, the sequences, or the orders of the constituent elements are not limited by the terms. When one constituent element is described as being "connected", "coupled", or "attached" to another constituent element, it should be understood that one constituent element can be connected or attached directly to another constituent element, and an intervening constituent element can also be "connected", "coupled", or "attached" to the constituent elements.

The same name may be used to describe an element included in the example embodiments described above and an element having a common function. Unless otherwise mentioned, the descriptions on the example embodiments may be applicable to the following example embodiments and thus, duplicated descriptions will be omitted for conciseness.

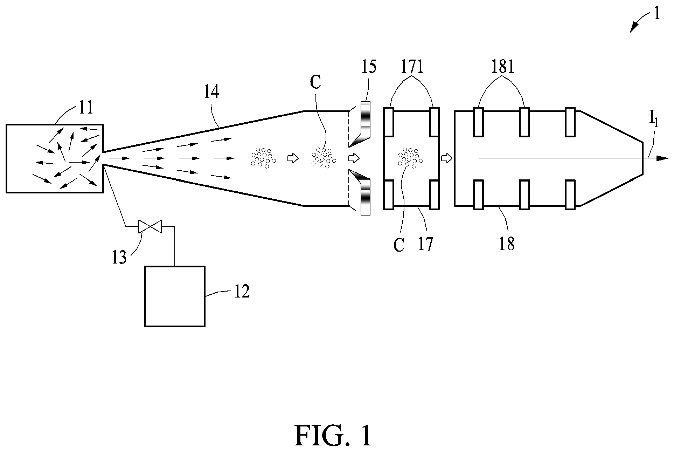

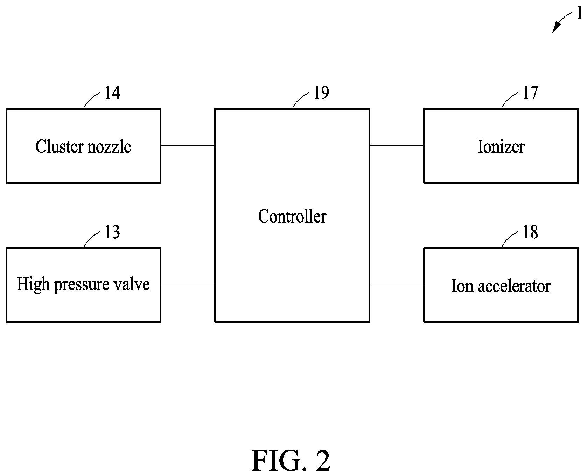

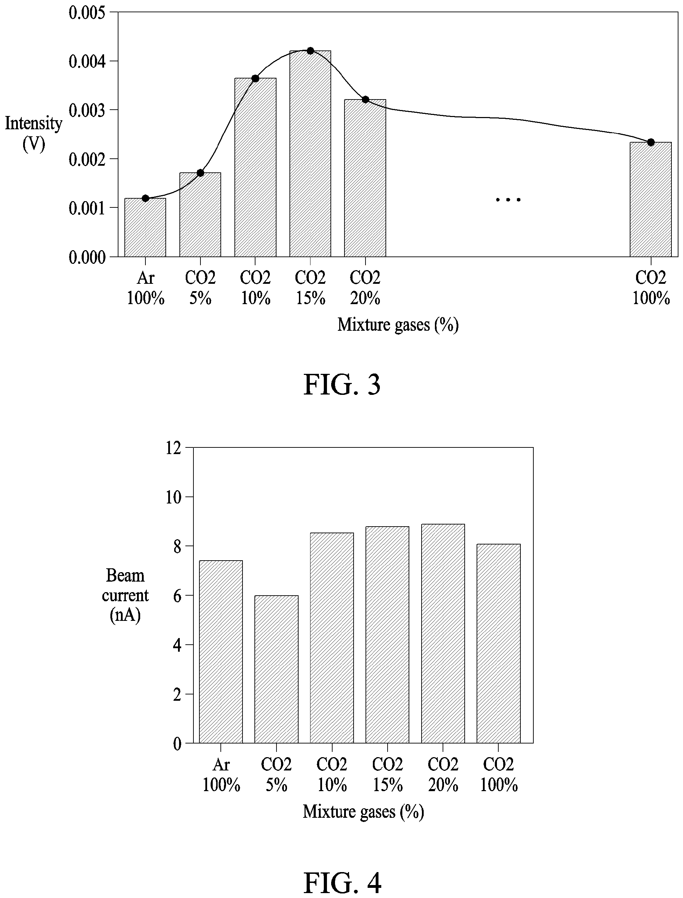

FIG. 1 is a diagram illustrating a mixed gas cluster ion beam generator according to an example embodiment, and FIG. 2 is a block diagram illustrating a mixed gas cluster ion beam generator according to an example embodiment. FIG. 3 is a graph illustrating changes in an intensity of a secondary ion measured based on a mixing ratio of gas used in a mixed gas cluster ion beam generator according to an example embodiment. FIG. 4 is a graph illustrating changes in current of a primary ion beam measured based on a mixing ratio of gas used in a mixed gas cluster ion beam generator according to an example embodiment.

Referring to FIGS. 1 to 4, a mixed gas cluster ion beam generator 1 may generate a gas cluster ion beam (GCIB) using a cluster formed of a mixed gas that is a mix of different types of gas as an ion source.

For example, the mixed gas cluster ion beam generator 1 may form a gas cluster C by mixing a first gas with a second gas which is different from the first gas and has a lower melting point than the first gas.

The mixed gas cluster ion beam generator 1 may include a nozzle chamber 11, a high pressure vessel 12, a cluster nozzle 14, a high pressure valve 13, a skimmer 15, an ionizer 17, an ion accelerator 18, and a controller 19.

The nozzle chamber 11 may contain a mixed gas that is a mix of the first gas and the second gas to generate the gas cluster C. The nozzle chamber 11 may be connected to the cluster nozzle 14 and may spray the first gas contained in the nozzle chamber 11 through the cluster nozzle 14.

For example, the first gas may be argon (Ar). However, besides Ar, gas including a monoatomic molecule, a diatomic molecule, or a polyatomic molecule, such as water (H₂O) or fullerene (C₆₀) may also be used for the first gas.

The high pressure vessel 12 may contain the mixed gas that is the mix of the first gas and the second gas to form the gas cluster C. Here, the mixed gas contained in the nozzle chamber 11 may be a "first mixed gas" and the mixed gas contained in the high pressure vessel 12 may be a "second mixed gas". Meanwhile, the first mixed gas and the second mixed gas are distinguished by where each is contained and may be identical to each other in a constituent element and composition. The high pressure vessel 12 may be connected to the cluster nozzle 14 and the second mixed gas contained in the high pressure vessel 12 may be provided to the cluster nozzle 14 like the first mixed gas.

For example, the second gas may be carbon dioxide (CO₂). However, the second gas may be not only CO₂ but also another different gas having a lower melting point than the first gas.

The cluster nozzle 14 may receive the first gas and the second gas from the nozzle chamber 11 and the high pressure vessel 12 and may spray the first gas and the second gas in a form of the gas cluster C. For example, the cluster nozzle 14 may generate the gas cluster C formed of a plurality of molecular crowding by rapidly expanding a mixed gas of Ar and CO₂ received from the nozzle chamber 11 and the high pressure vessel 12.

The high pressure valve 13 may be installed in a flow path through which the second mixed gas flows from the high pressure vessel 12 to the cluster nozzle 14 and may control fluid pressure of the second mixed gas provided to the cluster nozzle 14.

According to the control by the high pressure valve 13, fluid pressure of a mixed gas (for example, the first mixed gas and the second mixed gas) flowing into the cluster nozzle 14 may be controlled. In this way, a size of the gas cluster C sprayed by the cluster nozzle 14 may be adjusted.

The skimmer 15 may select the gas cluster C for using as an ionization source among the gas cluster C sprayed from the cluster nozzle 14.

For example, the skimmer 15 may be located between the cluster nozzle 14 and the ionizer 17 and may filter the gas cluster C which does not move toward the ionizer 17 among the gas cluster C sprayed from the cluster nozzle 14.

The ionizer 17 may ionize the gas cluster C sprayed from the cluster nozzle 14. The ionizer 17 may ionize the gas cluster C by colliding an electron with the gas cluster C contained inside of the ionizer 17.

For example, the ionizer 17 may include a plurality of electrodes 171 installed at intervals along a direction to accelerate the ionized gas cluster C and may accelerate the gas cluster C along an irradiation direction of a GCIB I₁ by generating a potential difference to the plurality of electrodes 171.

The ion accelerator 18 may generate the GCIB I₁ to be output to outside by performing high-energy acceleration on the ionized gas cluster C ionized by the ionizer 17.

For example, the ion accelerator 18 may include a plurality of electrodes 181 disposed along an irradiation direction of the GCIB I₁ and may accelerate the ionized gas cluster C by a potential difference generated in the plurality of electrodes 181.

For example, a velocity, energy, a density of the GCIB I₁ irradiated to outside or a number of molecules or a size of the gas cluster C forming the GCIB I₁ may be adjusted by a voltage applied to the plurality of electrodes 181 of the ion accelerator 18.

The controller 19 may control a process of emitting the GCIB I₁ to outside by generating the gas cluster C which is a mixed gas that is a mix of the first gas and the second gas by the mixed gas cluster ion beam generator 1 and ionizing the gas cluster C.

For example, the controller 19 may control fluid pressure of mixed gas flowing into the cluster nozzle 14 by controlling the high pressure valve 13.

Referring to Table 1 below and FIG. 3, experimentally measured data on an intensity of a secondary ion generated based on an actual mixing ratio of Ar and CO₂ when generating the GCIB I₁ by a mixed gas of Ar and CO₂ is shown.

Here, the secondary ion generated by a hit by a mixed gas cluster may be 2,2',2"-(1,3,5-Benzinetriyl)-tris(1-phenyl-1-H-benzimidazole) (TPBI) used for an organic light emitting material. An increase in the intensity of the secondary ion may represent an increase in analysis sensitivity of the mass spectrometer.

**[Table 1]**

| **Mixed gas (%)** | **Intensity (au)** |
|---|---|
| Ar 100% | 0.00119 |
| CO₂ 5% | 0.00172 |
| CO₂ 10% | 0.00365 |
| CO₂ 15% | 0.00425 |
| CO₂ 20% | 0.00324 |
| ... | ... |
| CO₂ 100% | 0.00236 |

As shown in Table 1 and a graph of FIG. 3, an intensity of a secondary ion may increase as a mixing amount of CO₂ increases in a range in which a ratio of CO₂ is 0% to 15% in a mixed gas of Ar and CO₂.

Here, a significantly high intensity secondary ion may be generated in a range in which a ratio of CO₂ is 10% to 20%, more desirably, 10% to 17.5% compared to other ranges.

More particularly, in a range in which the ratio of CO₂ is 5% to 10%, an intensity increase rate of the secondary ion may drastically increase compared to other adjacent ranges, and in a range in which the ratio of CO₂ is 17.5% to 20%, an intensity of the secondary ion may drastically decrease.

As a result, the effect that the intensity of the secondary ion in a range in which the ratio of CO₂ is 10% to 17.5% is higher by 247% (0.00425 ÷ 0.00172) than in a range in which the ratio of CO₂ is less than 5%, and the intensity of the secondary ion is higher by 131% (0.00425 ÷ 0.00324) than in a range in which the ratio of CO₂ is greater than 20%, may be remarkable.

As a result, by adjusting a ratio of CO₂ in a mixed gas to be 10% to 17.5%, a GCIB I₁ may be generated in which the intensity of the secondary ion is three times higher compared to when only Ar is used, and which may be significantly higher in density than other GCIBs generated in other ranges of mixing ratios of CO₂.

Referring to FIG. 4, experimentally measured data on a magnitude of current of the GCIB I₁ generated based on an actual mixing ratio of Ar and CO₂ may be identified when generating the GCIB I₁ in a mixed gas of Ar and CO₂.

As shown in FIG. 4, current of the GCIB I₁ generated in a range in which a ratio of CO₂ is 10% to 20% in the mixed gas of Ar and CO₂ may be measurably higher than current of GCIBs generated in other ranges of mixing ratios of CO₂.

Accordingly, an intensity of a secondary ion as well as current of the GCIB I₁ may be increased by adjusting a ratio of CO₂ in a mixed gas (for example, the first mixed gas and/or the second mixed gas) to be 10% to 20%, more desirably, 10% to 17.5%.

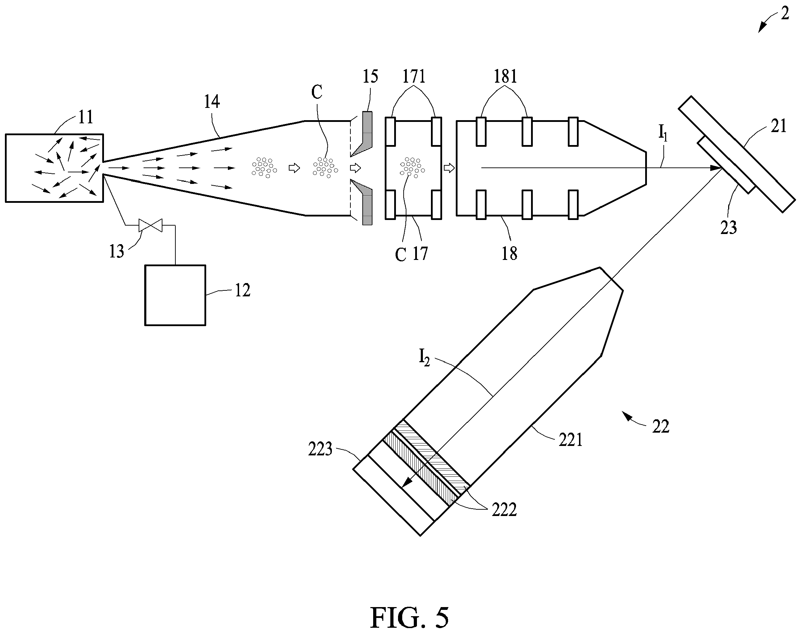

FIG. 5 is a diagram illustrating a mass spectrometer including a mixed gas cluster ion beam generator according to an example embodiment.

Referring to FIG. 5, a mass spectrometer 2 may be a time of flight (TOF) secondary ion mass spectrometer (SIMS) analyzing an element of a sample 23 to be measured by measuring a mass of a secondary ion I₂ emitted by irradiating a primary ion beam using the mixed gas cluster ion beam generator 1 of FIGS. 1 and 2 as a primary ion beam source to the sample 23.

The mass spectrometer 2 may include the mixed gas cluster ion beam generator 1, a sample plate 21 to dispose the sample 23 to be measured, and an analyzer 22 to analyze the secondary ion I₂ emitted by irradiating a primary ion beam I₁ irradiated from the mixed gas cluster ion beam generator 1 to the sample 23.

For example, the analyzer 22 may include an ion passage 221 to receive the secondary ion I₂ emitted from the sample 23 along a flight direction, a detector 223 installed in the ion passage 221 to detect the secondary ion I₂ inflowing into the passage 221 and a microchannel plate 222 installed in the ion passage 221 to amplify and lead the secondary ion I₂ to proceed to the detector 223.

The mass spectrometer 2 may enhance transference number of the secondary ion I₂ emitted from the sample 23 since the GCIB I₁ having a high density may be formed through the mixed gas cluster ion beam generator 1.

In other words, by being capable of irradiating a primary ion beam I₁ having a high density and small energy diffusion width to the sample 23, an efficiency in secondary ionization of the sample 23 may be enhanced, and as a result, analysis performance of the mass spectrometer 2 may be enhanced.

In addition, increasing current of the primary ion beam I₁ for depth profiling analysis, may have an advantage that a time required for analyzing the sample 23 may be reduced.

The components described in the example embodiments may be implemented by hardware components including, for example, at least one digital signal processor (DSP), a processor, a controller, an application-specific integrated circuit (ASIC), a programmable logic element, such as a field programmable gate array (FPGA), other electronic devices, or combinations thereof. At least some of the functions or the processes described in the example embodiments may be implemented by software, and the software may be recorded on a recording medium. The components, the functions, and the processes described in the example embodiments may be implemented by a combination of hardware and software.

A number of example embodiments have been described above. Nevertheless, it should be understood that various modifications may be made to these example embodiments. For example, suitable results may be achieved if the described techniques are performed in a different order and/or if components in a described system, architecture, device, or circuit are combined in a different manner and/or replaced or supplemented by other components or their equivalents.

## Claims

1. A mixed gas cluster ion beam generator comprising:
a nozzle chamber to contain a first mixed gas which is a mixed gas that is a mix of a first gas and a second gas;
a cluster nozzle to spray gas received from the nozzle chamber in a cluster form;
an ionizer to ionize a gas cluster sprayed by the cluster nozzle; and
an ion accelerator to emit an ion beam to an outside by accelerating the gas cluster ionized by the ionizer by generating a potential difference to the ionized gas cluster.

2. The mixed gas cluster ion beam generator of claim 1, further comprising:
a skimmer to selectively transfer the gas cluster sprayed by the cluster nozzle to the ionizer.

3. The mixed gas cluster ion beam generator of claim 1, further comprising:
a high pressure vessel to contain a second mixed gas which is a mixed gas that is a mix of the first gas and the second gas; and
a high pressure valve to adjust a size of the gas cluster sprayed by the cluster nozzle by controlling fluid pressure of the second mixed gas flowing into the cluster nozzle from the high pressure vessel.

4. The mixed gas cluster ion beam generator of claim 1, wherein a melting point of the second gas is lower than a melting point of the first gas.

5. The mixed gas cluster ion beam generator of claim 4, wherein the first gas is argon, and the second gas is carbon dioxide.

6. The mixed gas cluster ion beam generator of claim 5, wherein a ratio of carbon dioxide in the mixed gas of the first gas and the second gas is 10% to 20%.

7. The mixed gas cluster ion beam generator of claim 5, wherein a ratio of carbon dioxide in the mixed gas of the first gas and the second gas is 10% to 17.5%.

8. Amass spectrometer comprising:
a mixed gas cluster ion beam generator;
a sample plate to support a sample to be hit by a gas cluster ion beam generated by the mixed gas cluster ion beam generator; and
an analyzer to detect a secondary ion secondarily emitted from a surface of the sample,
wherein the mixed gas cluster ion beam generator comprises:
a nozzle chamber to contain a first mixed gas which is a mixed gas that is a mix of a first gas and a second gas;
a cluster nozzle to spray gas received from the nozzle chamber in a cluster form;
an ionizer to ionize a gas cluster sprayed by the cluster nozzle; and
an ion accelerator to emit an ion beam to an outside by accelerating the gas cluster ionized by the ionizer by generating a potential difference to the ionized gas cluster.

9. A method of generating a mixed gas cluster ion beam, the method comprising:
providing a mixed gas of a first gas and a second gas to a cluster nozzle;
forming a gas cluster by spraying the mixed gas through the cluster nozzle;
ionizing the gas cluster; and
generating an ion beam by accelerating the ionized gas cluster.

10. The method of claim 9, wherein a melting point of the second gas is lower than a melting point of the first gas.

11. The method of claim 9, wherein the first gas is argon and the second gas is carbon dioxide.

12. The method of claim 11, wherein a ratio of carbon dioxide in the mixed gas is 10% to 20%.

13. The method of claim 11, wherein a ratio of carbon dioxide in the mixed gas is 10% to 17.5%.
